# EUROPEAN PATENT APPLICATION

(11) **EP 4 650 801 A1**
(43) Date of publication of application: **19.11.2025**
(21) Application number: 24175329.2
(22) Date of filing: 13.05.2024
(51) Int. Cl.: G01R 31/389

(54) **ASSISTED ESTIMATION OF INTERNAL BATTERY IMPEDANCE**

(71) Applicant: VOLVO TRUCK CORPORATION, 405 08 Göteborg (SE)
(72) Inventor: SINGH, Shailesh, 417 47 GÖTEBORG (SE); LILLMAA, Henri, 463 72 LÖDÖSE (SE); ALTAF, Faisal, 421 43 VÄSTRA FRÖLUNDA (SE)
(74) Representative: Kransell & Wennborg KB

(57) **Abstract**

In an aspect, a computer system (14) comprising processing circuitry (11) is provided. The processing circuitry (11) is configured to acquire (S101) an estimate of internal impedance of an energy storage system (ESS, 15), determine (S102) a degree of accuracy of the internal impedance estimate and if the degree of accuracy is considered insufficient, to control (S103, S104) application of an excitation signal to the ESS (15) such that a more accurate estimation of the internal impedance is obtained.

## Description

### TECHNICAL FIELD

The disclosure relates generally to estimating internal impedance of an energy storage system (ESS). In particular aspects, the disclosure relates to improving estimates which are not considered sufficiently accurate. The disclosure can be applied in heavy-duty vehicles, such as trucks, buses, construction equipment, marine vessels and even stationary applications. Although the disclosure may be described with respect to a particular vehicle, the disclosure is not restricted to any particular vehicle.

### BACKGROUND

Measuring internal impedance of a battery of an ESS of e.g. a vehicle is important for maintaining the overall health of the battery and ensuring the reliable operation of the vehicle. For instance, if the internal impedance increases over time, ability of the battery to carry current decreases, resulting in inability to provide loads with sufficient power and/or inability to receive sufficient charge power including regeneration, and the battery will eventually have to be replaced.

A battery management system of the vehicle will thus continuously measure the internal impedance of the battery for maintenance purposes.

Estimating internal battery impedance is a well-known process and is commonly performed by subjecting one or more battery packs of the ESS to a charge or discharge current signal (e.g. a pulse) referred to as an excitation signal and observe voltage response of the battery pack. However, depending on current values of operational parameters of the battery, such as State of Charge (SoC) and temperature, as well as amplitude, shape, duration and direction of the excitation signal being applied during the estimation (or a combination of one or more of these parameters), the internal impedance estimate will be more or less accurate.

### SUMMARY

According to a first aspect of the disclosure, computer system is provided comprising processing circuitry configured to acquire an estimate of internal impedance of an energy storage system (ESS), determine a degree of accuracy of the internal impedance estimate, and if the degree of accuracy is considered insufficient control application of an excitation signal to the ESS such that a more accurate estimation of the internal impedance is obtained.

The first aspect of the disclosure may seek to resolve an issue of estimating internal impedance of one or more battery packs of the ESS. A technical benefit may include to improve accuracy of the estimated internal impedance.

In some examples, the processing circuitry is configured to cause an excitation signal in the form of a current or power signal to be applied to the ESS and monitor the voltage response, wherein the internal impedance is estimated based on the applied current or power and the voltage response. A technical benefit may include to correctly estimate internal impedance.

In some examples, the processing circuitry is configured to apply the excitation signal as a battery charge or discharge signal. A technical benefit may include to be able to apply the excitation signal when the ESS is in a rested state.

In some examples, the processing circuitry is configured to associate the internal impedance estimate with a timestamp, and if the difference between current time and the timestamp exceeds a threshold value, the degree of accuracy is considered insufficient. A technical benefit may include to disregard outdated estimates.

In some examples, the processing circuitry is configured to assign an accuracy metric to the internal impedance estimate, and if the accuracy metric does not exceed an accuracy threshold, the accuracy of the estimate is considered to be insufficient. A technical benefit may include to be able to assess the accuracy of an estimate.

In some examples, the degree of accuracy is configured to depend on one or more of the parameters State of Charge (SoC) and temperature of the ESS and amplitude, direction, duration and waveform of the excitation signal being applied, wherein a specific parameter value range results in the accuracy metric exceeding the accuracy threshold. A technical benefit may include to improve accuracy of the estimated internal impedance.

In some examples, the applied excitation signal is configured to adjust one or more of said parameters in order to arrive at an accuracy metric exceeding the accuracy threshold. A technical benefit may include to improve accuracy of the estimated internal impedance.

In some examples, the processing circuitry is configured to, upon controlling the application of an excitation signal to the ESS such that a more accurate estimation of the internal impedance is obtained comprises, instruct a control module to directly apply said excitation signal to the ESS.

In some examples, the control module is an electronic control unit (ECU).

In some examples, the processing circuitry is configured to, upon controlling the application of an excitation signal to the ESS such that a more accurate estimation of the internal impedance is obtained, cause a function to perform an action configured to adjust battery load such that said excitation signal indirectly is applied to the ESS.

In some examples, the action to be performed comprises one or more of adjusting cooling or heating of, controlling lighting, activation of windscreen wipers, by connecting or disconnecting one or more battery packs of the ESS, and by changing charging current during a charging session.

In some examples, the processing circuitry is configured to acquire an estimate of internal impedance of the ESS being performed upon the ESS being in a rested state.

In some examples, the processing circuitry is configured to, upon controlling the application of an excitation signal to the ESS such that a more accurate estimation of the internal impedance is obtained, cause the excitation signal to be applied at a later occasion if the excitation signal cannot be currently applied.

In some examples, the processing circuitry is configured to, upon controlling a vehicle to apply an excitation signal to the ESS such that a more accurate estimation of the internal impedance is obtained, cause the excitation signal to be applied as a charge function when the vehicle is not in operation.

In some examples, the processing circuitry is configured to acquire the internal impedance estimate by performing the estimation based on an applied excitation current signal and resulting voltage response and determine the accuracy based on one or more of current operational parameters of the ESS, and one or more of amplitude, direction, duration and waveform of the excitation signal being applied, or acquiring a computed estimate and the determined accuracy from the ESS.

In some examples, the processing circuitry is configured to acquire the internal impedance estimate by acquiring the internal impedance estimate of an individual battery pack or cell of the ESS.

In some examples, a vehicle is provided comprising the computer system of the first aspect.

According to a second aspect of the disclosure, a computer-implemented method is provided comprising acquiring an estimate of internal impedance of an ESS, determining a degree of accuracy of the internal impedance estimate, and if the degree of accuracy is considered insufficient controlling the application of an excitation signal to the ESS such that a more accurate estimation of the internal impedance is obtained.

In some examples, a computer program product is provided comprising program code for performing, when executed by the processing circuitry, the method of the second aspect.

In some examples, a non-transitory computer-readable storage medium is provided comprising instructions which when executed by the processing circuitry cause the processing circuitry to perform the method of the second aspect.

The above aspects, accompanying claims, and/or examples disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein. There are also disclosed herein control units, computer readable media, and computer program products associated with the above discussed technical benefits.

### BRIEF DESCRIPTION OF THE DRAWINGS

With reference to the appended drawings, below follows a more detailed description of aspects of the disclosure cited as examples.
FIG. 1 illustrates a vehicle in the form of a truck in which examples of the present disclosure may be implemented.
FIG. 2 shows an exemplary system diagram of a computer system with which the truck of FIG. 1 is equipped according to the present disclosure.
FIG. 3 shows a flowchart illustrating an example method according to the present disclosure.
FIG. 4 illustrates applying of a charge pulse to achieve a voltage response from which internal battery impedance can be estimated in an example.
FIG. 5 illustrates applying of a charge pulse to achieve a voltage response from which internal battery impedance can be estimated in another example.
FIG. 6 shows a flowchart illustrating another example method according to the present disclosure.
FIG. 7 is a schematic diagram of a computer system for implementing examples disclosed herein.

### DETAILED DESCRIPTION

Aspects set forth below represent the necessary information to enable those skilled in the art to practice the disclosure.

A battery management system (BMS) of a vehicle will occasionally perform estimation of the internal impedance of a battery of the vehicle. As mentioned, this is performed for maintenance purposes and generally if the internal impedance of the battery increases over time, the battery (or individual battery packs of the battery) will be replaced since increasing internal impedance ultimately results in inability to provide power to one or more loads and/or inability to receive sufficient charge power.

As is understood, an energy storage system (ESS) of a vehicle typically consists of numerous modules consisting of series and/or parallel connected battery cells which modules together form a battery pack. An ESS of a vehicle may include several battery packs. Thus, a number of separate battery packs may in combination supply the energy being output by the ESS, and it may be envisaged that the internal impedance of each individual battery pack (or cell) is estimated and if the estimation indicates that the internal impedance of the individual battery pack is too high, then the individual battery pack may be replaced with a new, functioning battery pack. The BMS of the vehicle manages the multiple battery packs comprised in the ESS.

Commonly, the BMS continuously and opportunistically looks for suitable battery pack excitation patterns and when such patterns occur, the BMS carries out the internal impedance estimation. Excitation signals creating a suitable battery pack excitation pattern may be applied to a battery pack by a component such as an external charger, a high-voltage (HV) DC-DC converter, an HV electrical motor, etc. Estimation of internal battery impedance is thus performed by subjecting the battery packs of the ESS to a charge or discharge current pulse and observe voltage response of the battery packs.

However, depending on current values of operational parameters of the battery pack, such as SoC and temperature, as well as amplitude, shape, duration and direction of the pulse being applied during the estimation, the internal impedance estimate will be more or less accurate. Suitable excitation signals, i.e. physical charge or discharge waveforms, resulting in an accurate impendence estimation may in practice rarely occur at all during operation of the vehicle. A problem is thus that the accuracy of the internal impedance cannot be ensured.

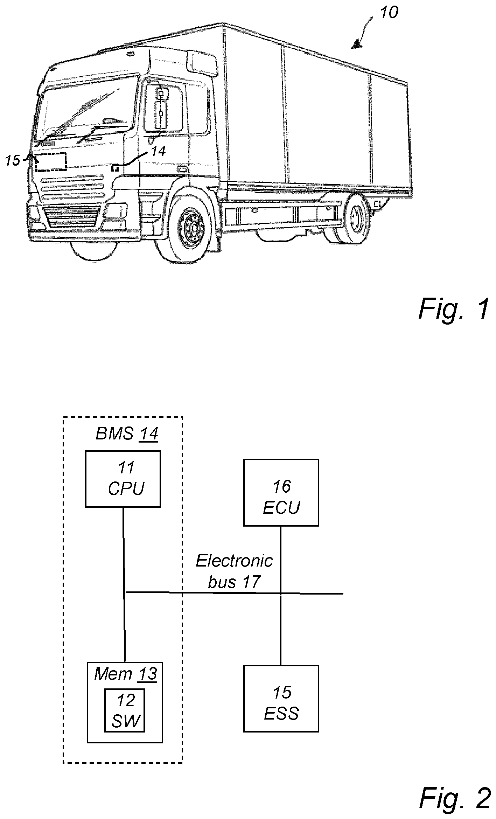

FIG. 1 illustrates a vehicle in the form of a truck 10 in which examples of the present disclosure may be implemented, the truck 10 being equipped with a computer system 14 in the form of the previously mentioned BMS controlling the battery packs of the truck 10.

Further illustrated in FIG. 1 is the ESS 15 arranged to provide electric energy for electric propulsion of the truck 10. The ESS 15 comprises the battery packs controlled by the BMS 14.

Although the vehicle 10 in FIG. 1 is depicted as a heavy-duty truck, examples of the present disclosure may be implemented in other types of vehicles, such as in passenger cars, busses, light-duty trucks, mid-duty trucks, construction equipment, motorcycles, marine vessels, etc.

FIG. 2 shows an exemplary system diagram of the computer system 14 with which the truck 10 of FIG. 1 is equipped according to the present disclosure. The computer system 14 will in the following be exemplified by the BMS being utilized for managing the ESS 15. Also shown in FIG. 2 is a so-called Electronic Control Unit (ECU) 16 controlling general operation of the truck 10. As is understood, the ECU 16 generally controls numerous components of the truck 10.

The BMS 14 generally comprises processing circuitry 11 embodied in the form of one or more microprocessors arranged to execute a computer program (SW) 12 downloaded to a storage medium (Mem) 13 associated with the microprocessor, such as a Random Access Memory (RAM), a Flash memory or a hard disk drive. The processing circuitry 11 is arranged to cause the BMS 14 to perform desired operations when the appropriate computer program 12 comprising computer-executable instructions is downloaded to the storage medium 13 and executed by the processing circuitry 11. The storage medium 13 may also be a computer program product comprising the computer program 12. Alternatively, the computer program 12 may be transferred to the storage medium 13 by means of a suitable computer program product, such as a Digital Versatile Disc (DVD) or a memory stick. As a further alternative, the computer program 12 may be downloaded to the storage medium 13 over a network. The processing circuitry 11 may alternatively be embodied in the form of a digital signal processor (DSP), an application specific integrated circuit (ASIC), a field-programmable gate array (FPGA), a complex programmable logic device (CPLD), etc. The processing circuitry 11 will in the following be referred to as a central processing unit (CPU).

The BMS 14 is further in communicative communication with the ECU 16 to which the BMS 14 may transmit control signals for controlling various components of the truck 10, e.g. the previously mentioned external charger, HV DC-DC converter or HV electrical motor in order to apply excitation signals to one or more of the battery packs of the ESS 15. As is understood, it may be envisaged that the BMS 14 sends control signals directly to these components (without the signals passing via the ECU 16). In examples described below, the BMS 14 will be illustrated to instruct the ECU 16 to apply excitation signals to the ESS 15 for enabling estimation of the internal battery impedance.

Communication between the various components illustrated in FIG. 2 may occur via an electronic communication bus 17 such as e.g., a Controller Area Network (CAN) bus, a Local Interconnect Network (LIN) bus, an Ethernet bus, etc.

As mentioned, depending on operational parameters of the battery packs of the ESS 15, such as SoC and temperature, as well as amplitude, shape, direction, etc., of the charge/discharge pulse being applied to one or more of the battery packs of the ESS 15 for estimating the internal impedance based on the voltage response of the battery pack, the internal impedance estimate may be more or less accurate for the given set of operational parameters where poor accuracy is undesirable; it is preferred that accuracy of the estimate can be ensured. As is understood, it may be that the ESS 15 itself estimates the internal impedance or one or more battery packs, or alternatively the BMS 14 performs the estimation, possibly after having been supplied with the operational parameters by the ESS 15. Generally, the internal impedance is continuously estimated.

This is resolved in an example of the present disclosure as will be described by the BMS 14 facilitating accurate estimation of the internal impedance of the battery packs of the ESS 15.

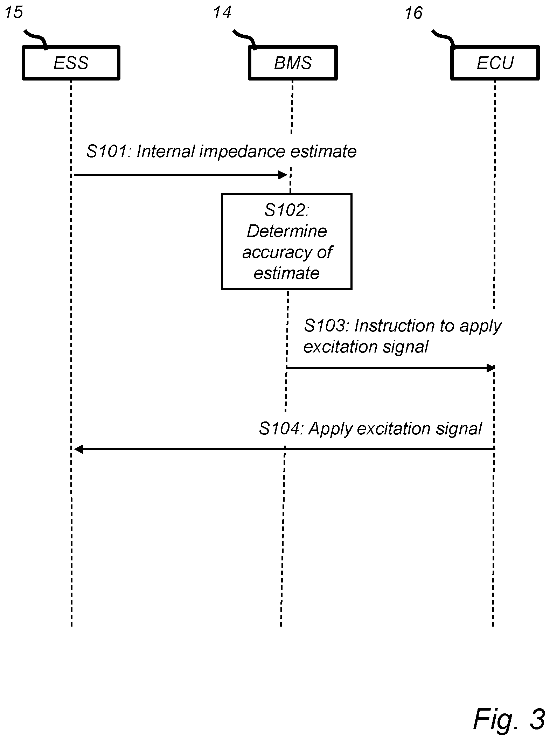

FIG. 3 shows a signaling diagram illustrating an example method of estimating internal impedance of the battery packs of the ESS 15 according to the present disclosure.

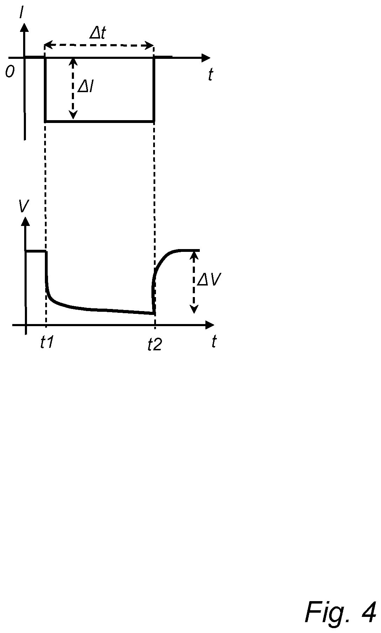

FIG. 4 shows in an upper illustration a current discharge pulse with amplitude ΔI being applied to the battery 15 at time t1 and having a duration of Δt = t2 - 11, and in a lower illustration a voltage response of the battery 15 with amplitude ΔV as a result of the discharge pulse being applied. This method of estimating battery impedance is common in the art and referred to as hybrid pulse power characterization (HPPC). As is understood, there are numerous methods known in the art for estimating internal impedance, where HPPC is illustrated herein as one example of such estimation.

In a first step S 101, the BMS 14 acquires an estimate of the internal impedance of a battery pack of the ESS 15. As mentioned, this may include acquiring an estimate of the internal impedance of one or more individual battery packs of the ESS 15, or even an estimate of the internal impedance of one or more individual battery cells of a specific battery pack. As is understood, the estimate may be performed by a controller of the ESS 15 (even on a per-battery pack basis) and provided to the BMS 14 in S 101, or operational parameters of the ESS 15 required for performing an estimate may be supplied to the BMS 14, which in its turn performs the actual estimation of the internal impedance. It may be further be envisaged that the system comprises one BMS per battery pack and that the ESS controller controls these multiple BMSs, thereby acting as a master BMS. In such scenario, the estimate(s) may be performed by one or more of the BMSs and provided to the ESS controller, which further instructs the ECU to apply the excitation signals.

In this particular example, it is assumed that the BMS 14 instructs the ECU 16 to apply a discharge current pulse to the ESS 15 - also referred to as the *excitation signal* - and monitors the voltage response of the battery pack of the ESS 15 in view of the current pulse being applied to the battery pack, as illustrated in FIG. 4. In a basic example, the BMS 14 may estimate the internal impedance by applying Ohm's law, thereby taking into account the applied current pulse and the resulting voltage response. As is understood, it may be that the BMS 14 itself applies the excitation signal to the ESS 15. However, in a practical example, the BMS 14 will typically instruct the ECU 16 (via the bus 17) to apply the excitation signal to the ESS 15.

In this example, the BMS 14 will thus in step S101 monitor and acquire measurement values of the applied discharge current pulse and the resulting voltage response and thus compute an estimate of the internal impedance of the battery pack of the ESS 15.

Now, upon estimating internal impedance of the battery pack, there is typically a given range for certain operational parameters of the battery 15 where the estimate will be more accurate than an estimate taken where the operational parameters are outside of said range.

In an example, an accuracy metric is assigned to the estimate, and if the metric does not exceed an accuracy threshold, the accuracy is considered to be insufficient.

For instance, an internal impedance estimate may be acquired which has been performed at a battery temperature range 25-3 5°C for a given SoC and amplitude of the applied charged pulse. However, it may be that the current temperature is, say, 5°C which indicates that the acquired impedance estimated taken at 25-35°C likely is inaccurate and therefore should not be relied upon at this stage.

Thus, in this example, if in S102 the ECU 14 concludes from a temperature measurement that the current battery temperature is 5°C (and there is no available impedance estimate for this current temperature), the ECU 14 will determine that the accuracy of the internal impedance estimate taken at 25-35°C likely is poor (or at least not sufficiently high) and thus should not be relied upon.

For instance, if the temperature is in the preferred range of 25-35°C, the accuracy metric may be given a value of 1, wherein if the metric is below that temperature, the metric will gradually decrease with decreasing temperature.

In this particular example, a battery temperature of 5°C will not result in an accuracy metric exceeding the accuracy threshold, which may be set to e.g. 0.9 whereas a battery temperature of 5°C may be assigned an accuracy metric of, say, 0.3.

In other words, since the current temperature of 5°C differs to such a great extent to the temperature of 25-35°C for which the estimate is valid, the estimate cannot be relied upon.

Therefore, in S103, the BMS 14 may instruct the ECU 16 to apply a further excitation signal to the ESS 15 of a certain amplitude and duration (potentially identical to that pulse for which the current estimation was made) to increase the battery temperature.

Alternatively, the BMS 14 may refrain from instructing the ECU 16 to apply the excitation signal until the BMS 14 has ensured that the battery temperature indeed has reached a level of 25°C (which may take some time to reach if for instance the truck 10 has just been started). Alternatively, if the BMS 14 is capable of measuring the battery temperature, the BMS14instructs the ECU 16 in S103 to apply the appropriate excitation signal once the temperature has reached 25°C, whereupon the ECU 16 applies the excitation signal in S104 upon detecting that the battery temperature has reached 25°C.

Hence, a new estimate will be acquired by the BMS 14 based on the new excitation signal being applied by the ECU 16 at the temperature of 25°C, which estimate advantageously will be accurate in contrast to the previous estimate taken at 5°C. It may even be envisaged that the previously acquired impedance estimate is re-used (assuming that it is not considered to be outdated), since it well may be accurate given that the battery temperature now is at 25°C.

In another example, the BMS 14 determines that the most recently computed estimate of the internal impedance is not up to date. The internal impedance may have drifted since, and consequently the estimate accuracy may have deteriorated.

Again with refence to FIG. 3, the ECU 14 acquires in S101 an estimate of the internal impedance of a battery pack of the ESS 15. In this example, a previously computed estimate is fetched by the BMS 14 from e.g. a storage comprising various operational parameters of the truck 10, a storage in the ESS 15 or the local memory 13 of the BMS 14, which estimate is associated with a timestamp indicating at which time instance the acquired estimate was computed.

In S 102, the BMS 14 concludes that the estimate was not computed sufficiently recently (such as for instance more than 24 hours ago) and thus determines that accuracy of the estimate is insufficient.

The BMS 14 will as a result in S 103 instruct the ECU 16 to apply an excitation signal to the ESS 15. Upon the ECU 16 applying the excitation signal in S 104 (cf. FIG. 4), the BMS 14 will advantageously monitor the voltage response and compute a new, up to date estimate being accurate.

In an example, it is envisaged that the BMS 14 not necessarily instructs the ECU 16 to apply a direct excitation signal to the ESS 16 in the form of a current pulse, but may alternatively affect other functional components which ultimately has the effect that an indirect excitation signal is applied such that an internal impedance estimate can be computed.

Such an indirect excitation signal may be achieved by adjusting battery load caused by other components of the truck 10. For instance, if a step down in the excitation signal is required (as illustrated in FIG. 4) for parameter(s) to reach a range where an accurate estimate can be made, such as e.g. an adequate current amplitude ΔI of the excitation signal is reached, the cooling may e.g. temporarily be turned off, the heating may be lowered, the windscreen wiper is temporarily activated, etc.

In another example, an excitation signal may be generated by connecting and disconnecting one or more battery packs in the ESS 15. Connecting/disconnecting one battery packs to/from the ESS 15 will generate a step type waveform on other battery packs, which can be used to assist impedance estimation. Also, an excitation signal can be generated bv changing charging current during a charging session.

Indirect excitation signals may be generated by controlling HV loads/components such as HV heater for heating, electric air conditioner, HV pumps, HV fans, HV DCDC converter (converting higher voltage to lower voltage, such as 24V and/or 12V),

In another example, an estimate is only performed if the ESS 15 (i.e. battery, battery pack or cell) is in a rested state. For instance, it may be that the BMS 14 in S103 instructs the ECU 16 to apply an excitation signal only when the battery pack of the ESS 15 is in a (relatively) rested state. For example, an excitation signal may be applied for internal impedance estimation in a situation where the truck 10 is in an idle state, for instance upon stopping at a red light, in contrast to e.g. when the truck 10 is travelling on a highway.

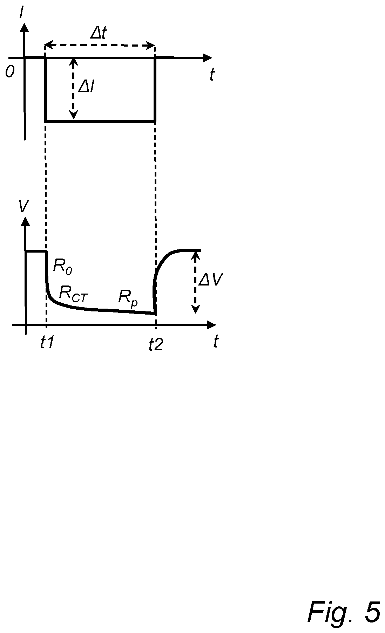

FIG. 5 shows a more detailed illustration of the voltage response of FIG. 4. In FIG. 5, it is illustrated that the estimated internal impedance in practice may depend on the duration Δt of the current pulse being applied.

Hence, the internal impedance estimate consists of three parts: (i) Ohmic impedance R₀ resulting in the instantaneous voltage drop and is dominant up to 0.1 seconds, (ii) charge transfer impedance R_{CT} occurring after R₀ and up to 2-5 seconds and (iii) polarization impedance Rₚ occurring from approximately 5 seconds.

In other words, the BMS 14 will take into account duration of the excitation signal upon estimating the internal impedance; for a long-duration pulse (i.e. greater than 5 seconds), all three impedance parts is taken into account while for short- and medium-duration pulses, only R₀ and R_{CT} are taken into account. As discussed with reference to FIG. 4, amplitude ΔI of the applied current is typically also taken into account as well as shape of the excitation signal (step signal, pulse signal, AC signal, etc,).

In a further example, if the requested action of the instruction of S 103 for some reason cannot be currently performed, it may be stored and performed at a later occasion. Thus, the excitation signal of S 104 may be applied to the ESS 15 at a later and more suitable occasion.

In addition, an example of opportunistic and minimal impact to end user function could be overnight charging, where the charging function could be manipulated to provide relaxation and excitation periods and pulses, respectively.

As previously mentioned, it may be that the estimation is accurate for an SoC of, say, 90% but not for an SoC of 50%. Thus, a particular estimate will generally have to be associated with particular SoC to be accurate.

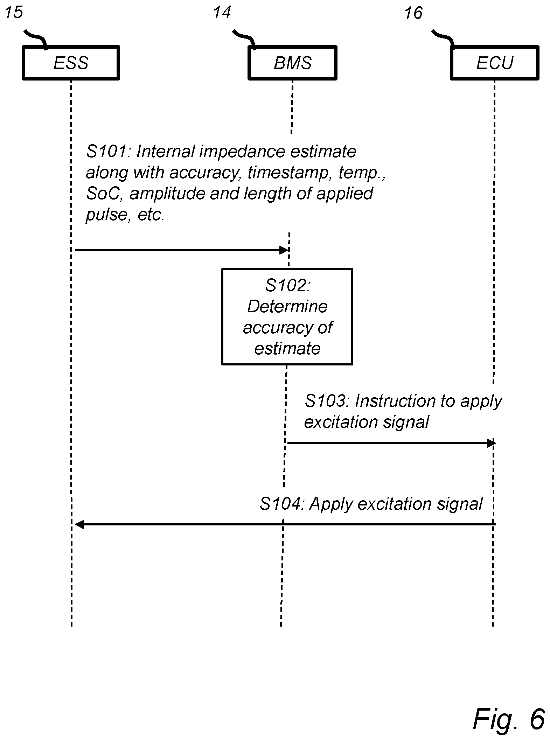

FIG. 6 shows a signaling diagram illustrating an example method of estimating internal impedance of a battery pack of the ESS 15 according to the present disclosure.

In a first step S101, the ECU 14 acquires an estimate of the internal impedance of the battery pack of the ESS 15. In this particular example, the ESS 15 itself (being provided with processing capacity in the form of e.g. one or more microprocessors) computes the internal impedance estimate and sends the estimate to the ECU 14 in S 101 along with required data.

Hence, in a first example, the ESS 15 may send the internal impedance estimate along with an accuracy measure indicating the accuracy of the computed estimate in S 101, wherein the BMS 14 determines from the accuracy measure that the accuracy is poor and thus instructs the ECU 16 in S 103 to apply an excitation signal in S 104 such that a new, accurate estimate can be computed.

In a second example, the estimate is accompanied by one or more of operational parameters of the battery pack of the ESS 15 such as temperature and/or SoC, timestamp indicating when the estimate was computed, and/or characteristics of the excitation signal that was applied when the estimate was computed, e.g. amplitude, direction (charge/discharge) and shape of the excitation signal. The BMS 14 may thus itself determine accuracy and an adequate excitation signal to be applied as a result of poor accuracy.

In a third example, all the data of the above given second example may be supplied to the BMS 14 along with the accuracy measure, based on which the BMS 14 determines the excitation signal to be applied by the ECU 16 for computing a new estimate.

In an example, characteristics of the excitation signals that was applied when the (poor) estimate was computed may be utilized to determine the accuracy of the estimate. For instance, with reference to FIG. 5, if the excitation signal has a long duration Δt of over 5 seconds, then the three parts of the internal impedance estimate should be taken into account R₀, R_{CT} and Rₚ, whereas in case of shorter duration only R₀ and R_{CT} are taken into account. As is understood, this will affect the accuracy of the estimate; if for example a long duration pulse is applied, all three parts should be taken into account for the estimate to become accurate.

Thus, as shown in the above examples, an ESS 15 (or even an individual battery pack of the ESS) or an BMS 14 estimates the internal impedance of the individual battery pack or cell based on a charge/discharge excitation signal being applied to the battery pack or cell. The signal may take on many forms, such as step, pulse, AC, etc. Depending on parameters including SoC, temperature, and amplitude, shape and direction (i.e. charge or discharge) of the excitation signal, this estimate will be more or less accurate. Generally, there is a preferred range of values for the parameters where the estimate will be at its most accurate. If the parameter values stray too far from that the range, the estimate will be inaccurate. As is understood, during operation of the vehicle accommodating the ESS 15, conditions may prevail which does not produce this ideal parameter value range. Examples shown herein resolves issues relating to poor internal impedance estimates.

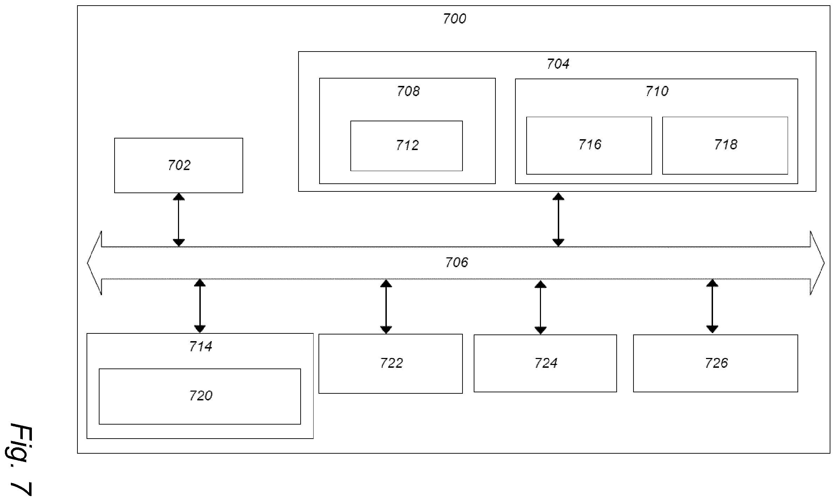

FIG. 7 is a schematic diagram of a computer system 700 for implementing examples disclosed herein. The computer system 700 is adapted to execute instructions from a computer-readable medium to perform these and/or any of the functions or processing described herein. The computer system 700 may be connected (e.g., networked) to other machines in a LAN, an intranet, an extranet, or the Internet. While only a single device is illustrated, the computer system 700 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 700 may comprise at least one computing device or electronic device capable of including firmware, hardware, and/or executing software instructions to implement the functionality described herein. The computer system 700 may include processing circuitry 702 (e.g., processing circuitry including one or more processor devices or control units), a memory 704, and a system bus 706. The computer system 700 may include at least one computing device having the processing circuitry 702. The system bus 706 provides an interface for system components including, but not limited to, the memory 704 and the processing circuitry 702. The processing circuitry 702 may include any number of hardware components for conducting data or signal processing or for executing computer code stored in memory 704. The processing circuitry 702 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 702 may further include computer executable code that controls operation of the programmable device.

The system bus 706 may be any of several types of bus structures that may further interconnect to a memory bus (with or without a memory controller), a peripheral bus, and/or a local bus using any of a variety of bus architectures. The memory 704 may be one or more devices for storing data and/or computer code for completing or facilitating methods described herein. The memory 704 may include database components, object code components, script components, or other types of information structure for supporting the various activities herein. Any distributed or local memory device may be utilized with the systems and methods of this description. The memory 704 may be communicably connected to the processing circuitry 702 (e.g., via a circuit or any other wired, wireless, or network connection) and may include computer code for executing one or more processes described herein. The memory 704 may include non-volatile memory 708 (e.g., read-only memory (ROM), erasable programmable read-only memory (EPROM), electrically erasable programmable read-only memory (EEPROM), etc.), and volatile memory 710 (e.g., random-access memory (RAM)), or any other medium which can be used to carry or store desired program code in the form of machine-executable instructions or data structures and which can be accessed by a computer or other machine with processing circuitry 702. A basic input/output system (BIOS) 712 may be stored in the non-volatile memory 708 and can include the basic routines that help to transfer information between elements within the computer system 700.

The computer system 700 may further include or be coupled to a non-transitory computer-readable storage medium such as the storage device 714, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 714 and other drives associated with computer-readable media and computer-usable media may provide non-volatile storage of data, data structures, computer-executable instructions, and the like. Computer-code which is hard or soft coded may be provided in the form of one or more modules. The module(s) can be implemented as software and/or hard-coded in circuitry to implement the functionality described herein in whole or in part. The modules may be stored in the storage device 714 and/or in the volatile memory 710, which may include an operating system 716 and/or one or more program modules 718. All or a portion of the examples disclosed herein may be implemented as a computer program 720 stored on a transitory or non-transitory computer-usable or computer-readable storage medium (e.g., single medium or multiple media), such as the storage device 714, which includes complex programming instructions (e.g., complex computer-readable program code) to cause the processing circuitry 702 to carry out actions described herein. Thus, the computer-readable program code of the computer program 720 can comprise software instructions for implementing the functionality of the examples described herein when executed by the processing circuitry 702. In some examples, the storage device 714 may be a computer program product (e.g., readable storage medium) storing the computer program 720 thereon, where at least a portion of a computer program 720 may be loadable (e.g., into a processor) for implementing the functionality of the examples described herein when executed by the processing circuitry 702. The processing circuitry 702 may serve as a controller or control system for the computer system 700 that is to implement the functionality described herein.

The computer system 700 may include an input device interface 722 configured to receive input and selections to be communicated to the computer system 700 when executing instructions, such as from a keyboard, mouse, touch-sensitive surface, etc. Such input devices may be connected to the processing circuitry 702 through the input device interface 722 coupled to the system bus 706 but can be connected through other interfaces, such as a parallel port, an Institute of Electrical and Electronic Engineers (IEEE) 1394 serial port, a Universal Serial Bus (USB) port, an IR interface, and the like. The computer system 700 may include an output device interface 724 configured to forward output, such as to a display, a video display unit (e.g., a liquid crystal display (LCD) or a cathode ray tube (CRT)). The computer system 700 may include a communications interface 726 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.
Example 1. A computer system (14) comprising processing circuitry (11) configured to:
   acquire (S101) an estimate of internal impedance of an energy storage system, ESS, (15);
   determine (S102) a degree of accuracy of the internal impedance estimate, and if the degree of accuracy is considered insufficient;
   control (S103, S104) application of an excitation signal to the ESS (15) such that a more accurate estimation of the internal impedance is obtained.
Example 2. The computer system (14) of example 1, the acquiring (S101) of the internal impedance estimate comprising:
   causing an excitation signal in the form of a current or power signal to be applied to the ESS (15) and monitoring the voltage response, wherein the internal impedance is estimated based on the applied current or power and the voltage response.
Example 3. The computer system (14) of example 2, the excitation signal being configured to be a battery charge or discharge signal.
Example 4. The computer system (14) of any one of the preceding examples, the internal impedance estimate being associated with a timestamp, and if the difference between current time and the timestamp exceeds a threshold value, the degree of accuracy is considered insufficient.
Example 5. The computer system (14) of any one of the preceding examples, wherein an accuracy metric is assigned to the internal impedance estimate, and if the accuracy metric does not exceed an accuracy threshold, the accuracy of the estimate is considered to be insufficient.
Example 6. The computer system (14) of any one of the preceding examples, the degree of accuracy depending on one or more of the parameters State of Charge, SoC, and temperature of the ESS (15) and amplitude, direction, duration and waveform of the excitation signal being applied, wherein a specific parameter value range results in the accuracy metric exceeding the accuracy threshold.
Example 7. The computer system (14) of example 6, the applied excitation signal being configured to adjust one or more of said parameters in order to arrive at an accuracy metric exceeding the accuracy threshold.
Example 8. The computer system (14) of any one of the preceding examples, the controlling (S103, S104) to apply an excitation signal to the ESS (15) such that a more accurate estimation of the internal impedance is obtained comprises:
   instructing (S103) a control module to directly apply (S104) said excitation signal to the ESS (15).
Example 9. The computer system (14) of example 8, the control module being an electronic control unit, ECU, (16).
Example 10. The computer system (14) of any one of the preceding examples, the controlling (S103, S104) to apply an excitation signal to the ESS (15) such that a more accurate estimation of the internal impedance is obtained comprises:
   causing a function to perform an action configured to adjust battery load such that said excitation signal indirectly is applied to the ESS (15).
Example 11. The computer system (14) of example 10, the action to be performed comprising one or more of adjusting cooling or heating, controlling lighting, activation of windscreen wipers, by connecting or disconnecting one or more battery packs of the ESS (15), and by changing charging current during a charging session..
Example 12. The computer system (14) of any one of the preceding examples, the acquiring (S101) of an estimate of internal impedance of the ESS (15) being performed upon the ESS being in a rested state.
Example 13. The computer system (14) of any one of the preceding examples, the controlling (S103, S104) to apply an excitation signal to the ESS (15) such that a more accurate estimation of the internal impedance is obtained comprises causing the excitation signal to be applied at a later occasion if the excitation signal cannot be currently applied.
Example 14. The computer system (14) of any one of the preceding examples, the controlling (S103, S104) of a vehicle (10) to apply an excitation signal to the ESS (15) such that a more accurate estimation of the internal impedance is obtained comprises applying the excitation signal as a charge function when the vehicle is not in operation.
Example 15. The computer system (14) of any one of the preceding examples, the acquiring (S101) of the internal impedance estimate comprising performing the estimation based on an applied excitation current signal and resulting voltage response and determining the accuracy based on one or more of current operational parameters of the ESS (15), and one or more of amplitude, direction, duration and waveform of the excitation signal being applied, or acquiring a computed estimate and the determined accuracy from the ESS (15).
Example 16. The computer system (14) of any one of the preceding examples, the acquiring (S101) of the internal impedance estimate comprising acquiring the internal impedance estimate of an individual battery pack or cell of the ESS (15).
Example 17. A vehicle (10) comprising the computer system (14) of any of examples 1-16.
Example 18. A BMS comprising the computer system (14) of any of examples 1-16.
Example 19. An ESS (15) comprising the computer system (14) of any of examples 1-16, the ESS (15) further comprising one or more battery packs.
Example 20. A computer-implemented method, comprising:
   acquiring (S101) an estimate of internal impedance of an energy storage system, ESS, (15);
   determining (S102) a degree of accuracy of the internal impedance estimate, and if the degree of accuracy is considered insufficient;
   controlling (S103, S104) application of an excitation signal to the ESS (15) such that a more accurate estimation of the internal impedance is obtained.
Example 21. A computer program product comprising program code (13) for performing, when executed by the processing circuitry (11), the method of example 20.
Example 22. A non-transitory computer-readable storage medium (12) comprising instructions (13) which when executed by the processing circuitry (11) cause the processing circuitry (11) to perform the method of example 20.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (14) comprising processing circuitry (11) configured to:
acquire (S101) an estimate of internal impedance of an energy storage system, ESS, (15);
determine (S102) a degree of accuracy of the internal impedance estimate, and if the degree of accuracy is considered insufficient;
control (S103, S104) application of an excitation signal to the ESS (15) such that a more accurate estimation of the internal impedance is obtained.

2. The computer system (14) of claim 1, the acquiring (S101) of the internal impedance estimate comprising:
causing an excitation signal in the form of a current or power signal to be applied to the ESS (15) and monitoring the voltage response, wherein the internal impedance is estimated based on the applied current or power and the voltage response.

3. The computer system (14) of claim 1 or 2, the excitation signal being configured to be a battery charge or discharge signal.

4. The computer system (14) of any one of the preceding claims, the internal impedance estimate being associated with a timestamp, and if the difference between current time and the timestamp exceeds a threshold value, the degree of accuracy is considered insufficient.

5. The computer system (14) of any one of the preceding claims, wherein an accuracy metric is assigned to the internal impedance estimate, and if the accuracy metric does not exceed an accuracy threshold, the accuracy of the estimate is considered to be insufficient.

6. The computer system (14) of any one of the preceding claims, the degree of accuracy depending on one or more of the parameters State of Charge, SoC, and temperature of the ESS (15) and amplitude, direction, duration and waveform of the excitation signal being applied, wherein a specific parameter value range results in the accuracy metric exceeding the accuracy threshold.

7. The computer system (14) of claim 6, the applied excitation signal being configured to adjust one or more of said parameters in order to arrive at an accuracy metric exceeding the accuracy threshold.

8. The computer system (14) of any one of the preceding claims, the controlling (S103, S104) to apply an excitation signal to the ESS (15) such that a more accurate estimation of the internal impedance is obtained comprises:
causing a function to perform an action configured to adjust battery load such that said excitation signal indirectly is applied to the ESS (15).

9. The computer system (14) of claim 8, the action to be performed comprising one or more of adjusting cooling or heating, controlling lighting, activation of windscreen wipers, by connecting or disconnecting one or more battery packs of the ESS (15), and by changing charging current during a charging session.

10. The computer system (14) of any one of the preceding claims, the controlling (S103, S104) of a vehicle (10) to apply an excitation signal to the ESS (15) such that a more accurate estimation of the internal impedance is obtained comprises applying the excitation signal as a charge function when the vehicle is not in operation.

11. The computer system (14) of any one of the preceding claims, the acquiring (S101) of the internal impedance estimate comprising performing the estimation based on an applied excitation current signal and resulting voltage response and determining the accuracy based on one or more of current operational parameters of the ESS (15), and one or more of amplitude, direction, duration and waveform of the excitation signal being applied, or acquiring a computed estimate and the determined accuracy from the ESS (15).

12. A vehicle (10) comprising the computer system (14) of any of claims 1-11.

13. A computer-implemented method, comprising:
acquiring (S101) an estimate of internal impedance of an energy storage system, ESS, (15);
determining (S102) a degree of accuracy of the internal impedance estimate, and if the degree of accuracy is considered insufficient;
controlling (S103, S104) application of an excitation signal to the ESS (15) such that a more accurate estimation of the internal impedance is obtained.

14. A computer program product comprising program code (13) for performing, when executed by the processing circuitry (11), the method of claim 13.

15. A non-transitory computer-readable storage medium (12) comprising instructions (13) which when executed by the processing circuitry (11) cause the processing circuitry (11) to perform the method of claim 13.
